(19) **Europäisches Patentamt / European Patent Office / Office européen des brevets**

(11) **EP 2 354 847 B1**

(12) **FASCICULE DE BREVET EUROPEEN**

(45) Date de publication et mention
de la délivrance du brevet:
**17.06.2015 Bulletin 2015/25**

(51) Int Cl.:
***G03F 7/00*** *(2006.01)*

(21) Numéro de dépôt: **11151798.3**

(22) Date de dépôt: **24.01.2011**

(54) **Moule pour la lithographie par nano-impression assistée uv et procédés de réalisation d'un tel moule**

Form für die UV-unterstützte Nano-Prägelithographie, und Herstellungsverfahren einer solchen Form

Mould for lithography by UV-assisted nanoprinting and methods for manufacturing such a mould

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.01.2010 FR 1050570**

(43) Date de publication de la demande:
**10.08.2011 Bulletin 2011/32**

(73) Titulaire: **Commissariat à l'Énergie Atomique et aux Énergies Alternatives
75015 Paris (FR)**

(72) Inventeur: **Landis, Stéfan
38500, Voiron (FR)**

(74) Mandataire: **Ilgart, Jean-Christophe et al
BREVALEX
95, rue d'Amsterdam
75378 Paris Cedex 8 (FR)**

(56) Documents cités:
**JP-A- 2004 125 874     US-A1- 2004 086 790
US-A1- 2010 015 270**

## Description

## DOMAINE TECHNIQUE

L'invention concerne un moule destiné à être utilisé pour réaliser une lithographie par nano-impression assistée par UV (procédé UV-NIL (NanoImprint Lithography)) .

L'invention concerne également les procédés de réalisation d'un tel moule.

## ÉTAT DE LA TECHNIQUE ANTÉRIEURE

La lithographie par nano-impression assistée par UV consiste à dupliquer des motifs par pressage d'un moule, transparent à une longueur d'onde d'utilisation située dans la gamme des UV (c'est-à-dire une longueur d'onde comprise entre 193 nm et 400 nm, de préférence entre 200 nm et 400 nm), dans un film de polymère photosensible aux UV disposé sur un substrat à imprimer et par application d'un rayonnement UV à travers ledit moule afin de photopolymériser le film de résine.

Les motifs reproduits dans le film de polymère sont ensuite gravés dans le substrat à imprimer, sous-jacent au film de polymère.

On parle de nano-impression car les motifs dupliqués ont une taille (longueur, largeur et/ou diamètre) comprise entre quelques nanomètres et plusieurs centaines de micromètres.

La nano-impression assistée par UV est généralement mise en ouvre par une technique dite de « step and repeat » : un moule ayant une surface de quelques $cm^2$ est mis en contact avec un film de résine disposé sur un substrat à imprimer ; le film de résine est exposé à une longueur d'onde d'utilisation située dans la gamme des UV ; le moule est ensuite détaché du film de résine et est déplacé en un autre endroit du substrat à imprimer. Ces étapes sont répétées jusqu'à ce que la surface totale du substrat à traiter soit imprimée.

Le principal inconvénient de cette technique est qu'il n'est pas possible d'imprimer deux puces adjacentes sans laisser une distance de séparation entre elles. Dans le meilleur des cas, cette distance est de quelques dizaines de micromètres, ce qui constitue une distance conséquente par rapport à la taille des puces et à la taille du moule : il y a donc beaucoup d'espace de perdu.

La principale cause de cette limitation vient du fait que le moule habituellement fabriqué pour réaliser la technique de « step and repeat » est entièrement transparent aux UV. Par conséquent, lors de l'exposition à une longueur d'onde d'utilisation située dans les UV, les UV modifient le film de résine présent sous les motifs imprimés, mais également en proche périphérie des motifs (diffusion latérale).

Cette diffusion latérale de la lumière du fait de la transparence du moule peut être limitée si les espaces situés entre les motifs sont recouverts d'une couche absorbant la lumière. Par exemple, le dépôt d'une couche de chrome sur la face d'un moule en quartz comprenant des motifs permettra de supprimer localement la transparence de ce moule. Toutefois, le dépôt de cette couche, réalisé après la lithographie et la gravure du moule, n'est pas simple à mettre en ouvre et il est en outre difficile de définir avec une grande précision la limite entre les zones transparentes et les zones absorbantes du moule. D'autre part, la présence de cette couche absorbant la lumière modifie les propriétés de surface du moule vis-à-vis du film de polymère utilisé lors de la nano-impression, ce qui peut induire de nouvelles problématiques (apparition de défauts, problème de mouillabilité...) .

Un autre inconvénient des moules transparents aux UV est qu'ils sont généralement rigides. En effet, les moules généralement utilisés pour réaliser une nano-impression assistée par UV sont en quartz (le quartz étant transparent pour des longueurs d'ondes supérieures à 193 nm).

Or, la structuration par des procédés classiques de lithographie/gravure de matériaux transparents aux UV et rigides, et en particulier du quartz, devient problématique lorsque les motifs à obtenir ont des dimensions inférieures à 100 nm.

D'autre part, plus un moule est rigide et plus il devient difficile d'obtenir un contact homogène (contact conforme) en tout point entre le moule et le film de résine. Il devient alors très difficile, voire impossible, d'imprimer des motifs avec une homogénéité satisfaisante. Par exemple, un moule en quartz a une rigidité telle que la surface maximale qu'il est possible d'imprimer en une seule étape à l'aide d'un tel moule est typiquement de quelques $cm^2$.

Au vu des inconvénients décrits ci-dessus, l'inventeur s'est donc fixé comme but de concevoir un moule pour lithographie par nano-impression assistée par une longueur d'onde déterminée dans lequel la distance nécessaire entre deux puces successives puisse être minimisée.

Il s'est également fixer pour but que ce moule puisse, en outre, comprendre des motifs de taille nanométrique et/ou avoir une surface supérieure à quelques $cm^2$.

Le document US2010/015270 A1 décrit un moule pour la lithographie par nano-impression (figure 3) dont la couche de support comporte des évidements.

## EXPOSÉ DE L'INVENTION

Ces buts sont atteints par un moule pour la lithographie par nano-impression assistée par une longueur d'onde déterminée λdét, comprenant une couche en un premier matériau comportant, sur une première face, une couche en un second matériau, qui est rigide, et dans laquelle sont réalisées n zone(s) structurée(s) avec des motifs de taille micrométrique ou nanométrique, n étant un nombre entier supérieur ou égal à 1, et, sur la face opposée à ladite première face, une couche en un troisième matériau, qui est rigide, dans laquelle sont ménagés n évidements en regard des n zones structurées, lesdits n évidements étant remplis d'un quatrième matériau pour former n portions,

la couche en troisième matériau ayant une épaisseur et une composition telles que sa transmittance à la lumière de longueur d'onde déterminée $\lambda_{dét}$ est inférieure à la transmittance à la lumière de longueur d'onde déterminée $\lambda_{dét}$ de l'une quelconque des n portions,

et les transmittances des couches de premier, de second et de troisième matériaux à la longueur d'onde déterminée $\lambda_{dét}$ étant telles que la transmission d'une lumière de longueur d'onde déterminée $\lambda_{dét}$ à travers les couches de premier, de second et de troisième matériaux est inférieure à la transmission de cette lumière de longueur d'onde déterminée $\lambda_{dét}$ à travers l'une quelconque des n portions et les couches de premier et second matériaux.

Le fait que la couche en second matériau soit rigide permet de conserver la géométrie des motifs lors de l'utilisation du moule en nano-impression.

Dans ce qui précède et ce qui suit, l'expression « structurée avec des motifs de taille micrométrique ou nanométrique », appliquée à une face ou à une couche, signifie que la face ou la couche en question comprend des motifs dont au moins une dimension choisie parmi la longueur, la largeur et le diamètre est inférieure à 1000 micromètres et supérieure à 1 micromètre, dans le cas de motifs de taille micrométrique, et est supérieure ou égale à 1 nanomètre et inférieure à 1000 nanomètres dans le cas de motifs de taille nanométrique.

Dans le cadre de l'invention, les motifs peuvent être en relief ou encaissés (en creux). Ils peuvent être dispersés de manière homogène dans les n zones, et sont de préférence équidistants au sein d'une même zone. Avantageusement, les motifs sont identiques (ils ont les mêmes dimensions et la même forme). Avantageusement, les n zones structurées sont identiques.

Dans ce qui précède et ce qui suit, le terme « rigide », appliqué à une couche, signifie que cette couche présente une déformation en flexion (flèche) inférieure à une valeur limite déterminée lorsqu'une pression déterminée est appliquée sur la surface de cette couche.

De même, dans ce qui précède et ce qui suit, le terme « souple », appliqué à une couche, signifie que cette couche présente une déformation en flexion supérieure ou égale à une valeur limite déterminée lorsqu'une pression déterminée est appliquée sur la surface de cette couche.

Pour déterminer la valeur limite, il faut effectuer quelques calculs simples. Par exemple, prenons le cas d'un moule en silicium et en quartz ayant les caractéristiques suivantes :

$$E_{Si} = 130 \text{ GPa} \quad E_{SiO2} = 71,7 \text{ GPa}$$
$$\nu_{Si} = 0,28 \quad \nu_{SiO2} = 0,16$$
$$h_{Si} = 750 \text{ } \mu m \quad h_{SiO2} = 6 \text{ mm}$$

où E est le module d'Young, $\nu$ est le coefficient de Poisson et h est la hauteur de la couche concernée.

La rigidité à la flexion d'une pièce est donnée par la formule suivant :

$$D = \frac{E \times h^3}{12 \times (1 - \nu^2)}$$

Pour une plaque carrée de côté a, ayant une épaisseur h, la déflexion maximale générée (en flexion) w est à peu prés égale à :

$$w \approx \frac{P \times a^4}{D}$$

Donc, si dans l'exemple ci-dessus la pression exercée uniformément sur le moule est égale à $2.10^5$ Pa et que le côté a des plaques a une valeur de $20.10^{-3}$ m, alors on a :

$$w_{Si} \approx 500 \text{ } \mu m$$

$$w_{SiO2} \approx 25 \text{ } \mu m$$

Par ces calculs, on a obtenu la flèche de chaque couche prise individuellement.

Pour obtenir la valeur limite permettant de considérer qu'une couche est souple ou rigide, il faut comparer la valeur de la flèche calculée et la valeur de la rugosité de surface (ou topographie) du substrat que l'on souhaite imprimer en utilisant le moule. En effet, lorsqu'on fait une impression, il faut avoir un contact intime (aussi appelé contact « conforme ») entre le moule et le substrat à imprimer ; il faut donc que toute la surface du moule soit en contact direct avec toute la surface du substrat à imprimer.

Par exemple, un substrat constitué d'une plaque de silicium de 200 mm de diamètre présente une rugosité de 50 $\mu$m (donnée fournie par le fournisseur de la plaque de silicium). Aussi, si la couche du moule a une flèche supérieure ou égale à la valeur de rugosité du substrat à imprimer donnée par le fabricant, à savoir 50 $\mu$m, cette couche sera considérée comme étant en un matériau souple par rapport au substrat que l'on cherche à imprimer. Par contre, si la valeur de la flèche de la couche du moule est inférieure à la valeur de rugosité du substrat à imprimer, la couche sera considérée comme étant un matériau rigide.

Ainsi, dans notre exemple, la couche de silicium ($w_{Si} \approx 500 \text{ } \mu m$) est considérée comme étant souple, tandis que la couche de quartz ($w_{SiO2} \approx 25 \text{ } \mu m$) est considérée comme étant rigide.

D'autre part, on rappelle que la transmittance d'un matériau est le rapport de l'énergie transmise à travers ce matériau sur l'énergie incidente reçue par ce matériau. Pour une substance donnée, avec une épaisseur et une longueur d'onde définies, la transmittance est une constante.

Avantageusement, la transmittance de la couche de troisième matériau est inférieure ou égale à 0,2 et la transmittance de chacune des n portions est supérieure ou égale à 0,65. De préférence, la transmittance de la couche de troisième matériau est inférieure à 0,1 et la transmittance de chacune des n portions est supérieure à 0,85.

Avantageusement, la transmission de la lumière de longueur d'onde déterminée $\lambda_{dét}$ à travers les couches de premier, de second et de troisième matériaux est inférieure ou égale à 20%, de préférence inférieure à 10%, et la transmission de cette lumière de longueur d'onde déterminée $\lambda_{dét}$ à travers l'une quelconque des n portions et les couches de premier et second matériaux est supérieure ou égale à 65%, de préférence supérieure à 85%.

De préférence, la transmittance de la couche en troisième matériau a une valeur inférieure ou égale à 2/3 de la valeur de la transmittance du matériau des n portions. En lithographie optique, on considère que l'on est capable, avec les résines actuelles, de différencier une zone exposée d'une zone non exposée si le contraste C est supérieur ou égal à 20%, le contraste ayant la formule suivante :

$$C = \frac{I_{max} - I_{min}}{I_{max} + I_{min}}$$

où $I_{max}$ est l'intensité lumineuse reçue dans une zone où la transmittance est maximale ($T_{max}$) à une longueur d'onde déterminée et $I_{min}$ est l'intensité lumineuse reçue dans une zone où la transmittance est minimale ($T_{min}$) à cette longueur d'onde déterminée.

Sachant que la transmittance est le rapport de l'intensité transmise à travers un matériau sur l'intensité incidente (intensité initiale $I_o$), on a :

$$I_{max} = T_{max} \times I_o$$

$$I_{min} = T_{min} \times I_o$$

et

$$C = \frac{T_{max} - T_{min}}{T_{max} + T_{min}}$$

Au final, pour un contraste 20%, on a $T_{min} \approx 0,66\ T_{max}$, c'est-à-dire environ 2/3.

Avantageusement, les n évidements ont une profondeur égale à l'épaisseur de la couche en troisième matériau.

Selon une première variante, le premier matériau est un matériau rigide et la couche en second matériau est présente uniquement au niveau des n zones structurées. Dans ce cas, le premier matériau, le second matériau, et éventuellement le troisième matériau, sont identiques.

Avantageusement, les n zones structurées sont réalisées dans la totalité de l'épaisseur de la couche en second matériau.

Avantageusement, les couches en premier et second matériau ont une épaisseur inférieure ou égale à 150 nm.

Selon une seconde variante, le premier matériau est un matériau souple et la couche en second matériau a une épaisseur non nulle en dehors des n zones structurées.

Avantageusement, le quatrième matériau des n portions est un matériau souple.

Avantageusement, la longueur d'onde déterminée $\lambda_{dét}$ est située dans la gamme des longueurs d'onde UV, de préférence entre 193 nm et 400 nm. Par exemple, si le moule est destiné à être utilisé pour réaliser une nano-impression assisté par UV à une longueur d'onde comprise entre 193 nm et 400 nm, la couche en second matériau peut être une couche de silicium. Il est alors aisé de réaliser la structuration selon des motifs de taille nanométrique dans une telle couche, étant donné que la lithographie/gravure nanométrique du silicium est maitrisée.

Avantageusement, la couche en premier matériau est en silice ou en nitrure de silicium, la couche en second matériau est en silice ou en nitrure de silicium, la couche en troisième matériau est en silicium et les n portions en quatrième matériau sont en polydiméthylsiloxane (PDMS).

L'invention concerne également un premier procédé de réalisation d'un moule tel que décrit ci-dessus pour la lithographie par nano-impression assistée par une longueur d'onde déterminée $\lambda_{dét}$. Ce premier procédé comprend les étapes suivantes :

a) fourniture d'un substrat initial ;
b) structuration d'une face dudit substrat initial, appelée face avant, selon un motif représentant l'empreinte négative des n zones structurées que l'on souhaite obtenir dans la couche en second matériau du moule ;
c) dépôt d'un empilement comprenant trois couches sur la face avant du substrat initial, la première couche recouvrant le relief formé à l'étape b) de structuration et formant la couche en second matériau du moule, ladite première couche et le substrat initial étant en des matériaux différents, la seconde couche recouvrant la première couche et formant la couche en premier matériau du moule, et la troisième couche recouvrant la seconde couche et formant la couche en troisième matériau du moule,
d) structuration de la troisième couche de manière à obtenir n évidements, les n évidements étant en regard des n zones structurées ;
e) formation des n portions du moule par dépôt d'une couche en quatrième matériau sur la troisième couche de manière à recouvrir les n évidements ;
f) retrait du substrat initial (13).

la troisième couche ayant une épaisseur et une composition telles que sa transmittance à la lumière de longueur d'onde déterminée $\lambda_{dét}$ est inférieure à la transmittance à la lumière de longueur d'onde déterminée $\lambda_{dét}$ de l'une quelconque des n portions,
et les transmittances des première, seconde et troisième couches à la longueur d'onde déterminée $\lambda_{dét}$ étant telles que la transmission d'une lumière de longueur d'onde déterminée $\lambda_{dét}$ à travers les première, seconde et troisième couches est inférieure à la transmission de cette lumière de longueur d'onde déterminée $\lambda_{dét}$ à travers l'une quelconque des n portions et les première et seconde couches.

Avantageusement, la transmittance de la troisième couche est inférieure ou égale à 0,2, de préférence inférieure à 0,1, et la transmittance de chacune des n portions est supérieure ou égale à 0,65, de préférence supérieure à 0,85.

Avantageusement, la transmission de la lumière de longueur d'onde déterminée $\lambda_{dét}$ à travers les première, seconde et troisième couches est inférieure ou égale à 20% et la transmission de cette lumière de longueur d'onde déterminée $\lambda_{dét}$ à travers l'une quelconque des n portions et les première et seconde couches est supérieure ou égale à 65%.

Avantageusement, l'étape b) comprend les étapes suivantes :

-   dépôt d'une couche de résine photosensible sur une face du substrat initial ;
-   insolation de la couche de résine photosensible selon un motif d'insolation représentant l'empreinte négative des n zones structurées que l'on souhaite obtenir dans la première couche ;
-   gravure de la couche de résine insolée ;
-   gravure des parties de la face du substrat initial non recouvertes par la couche de résine.

Avantageusement, l'étape d) comprend les étapes suivantes :

-   dépôt d'une couche de résine photosensible sur la face de la troisième couche ;
-   insolation de la couche de résine photosensible selon un motif d'insolation représentant l'empreinte positive des n évidements que l'on souhaite obtenir dans la troisième couche ;
-   gravure de la couche de résine insolée ;
-   gravure des parties de la face de la troisième couche non recouvertes par la couche de résine.

L'étape e), quant à elle, peut être obtenue en réalisant une gravure sélective du substrat initial ou encore en effectuant l'usinage de la face arrière du substrat initial, puis en effectuant une gravure sélective du substrat initial.

L'invention concerne également un second procédé de réalisation d'un moule tel que décrit ci-dessus pour la lithographie par nano-impression assistée par une longueur d'onde déterminée $\lambda_{dét}$. Ce second procédé comprend les étapes suivantes :

a) fourniture d'un empilement comprenant trois couches, la première couche formant la couche en second matériau du moule, la seconde couche recouvrant la première couche et formant la couche en premier matériau du moule, et la troisième couche recouvrant la seconde couche et formant la couche en troisième matériau du moule,
b) structuration de la première couche de l'empilement de manière à obtenir les n zones structurées ;
c) réalisation des n évidements dans la troisième couche de l'empilement, les n évidements étant en regard des n zones structurées ;
d) formation des n portions du moule par dépôt d'une couche en quatrième matériau sur la troisième couche de manière à recouvrir les n évidements ;

la troisième couche ayant une épaisseur et une composition telles que sa transmittance à la lumière de longueur d'onde déterminée $\lambda_{dét}$ est inférieure à la transmittance à la lumière de longueur d'onde déterminée $\lambda_{dét}$ de l'une quelconque des n portions,
et les transmittances des première, seconde et troisième couches à la longueur d'onde déterminée $\lambda_{dét}$ étant telles que la transmission d'une lumière de longueur d'onde déterminée $\lambda_{dét}$ à travers les première, seconde et troisième couches est inférieure à la transmission de cette lumière de longueur d'onde déterminée $\lambda_{dét}$ à travers l'une quelconque des n portions (4) et les première et seconde couches.

Avantageusement, la transmittance de la troisième couche est inférieure ou égale à 0,2, de préférence inférieure à 0,1, et la transmittance de chacune des n portions est supérieure ou égale à 0,65, de préférence supérieure à 0,85.

Avantageusement, la transmission de la lumière de longueur d'onde déterminée $\lambda_{dét}$ à travers les première, seconde et troisième couches est inférieure ou égale à 20% et la transmission de cette lumière de longueur d'onde déterminée $\lambda_{dét}$ à travers l'une quelconque des n portions et les première et seconde couches est supérieure ou égale à 65%.

Avantageusement, l'étape b) comprend les étapes suivantes :

-   dépôt d'une couche de résine photosensible sur la première couche de l'empilement ;

- insolation de la couche de résine photosensible selon un motif d'insolation représentant les motifs de taille micrométrique ou nanométrique agencés selon les n zones structurées à obtenir ;
- gravure de la couche de résine insolée ;
- gravure des parties de la face de la première couche non recouvertes par la couche de résine.

Avantageusement, l'étape c) comprend les étapes suivantes :

- dépôt d'une couche de résine photosensible sur la troisième couche de l'empilement ;
- insolation de la couche de résine photosensible selon un motif d'insolation représentant les n évidements à obtenir ;
- gravure de la couche de résine insolée ;
- gravure des parties de la face de la troisième couche non recouvertes par la couche de résine.

Avantageusement, dans les premier et second procédés ci-dessus, la longueur d'onde déterminée est une longueur d'onde située dans la gamme des longueurs d'onde UV, de préférence entre 193 et 400 nm.
De même, les n évidements dans les premier et second procédés ont avantageusement une profondeur égale à l'épaisseur de la troisième couche.

## BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 représente un premier exemple d'un moule selon l'invention,
- la figure 2 représente un second exemple d'un moule selon l'invention,
- la figure 3 représente un troisième exemple d'un moule selon l'invention,
- la figure 4 représente un quatrième exemple d'un moule selon l'invention,
- les figures 5a à 5h représentent les étapes du premier procédé de réalisation d'un moule selon l'invention,
- les figures 6a à 6e représentent les étapes du second procédé de réalisation d'un moule selon l'invention.

## EXPOSÉ DÉTAILLÉ DE MODES DE RÉALISATION PARTICULIERS

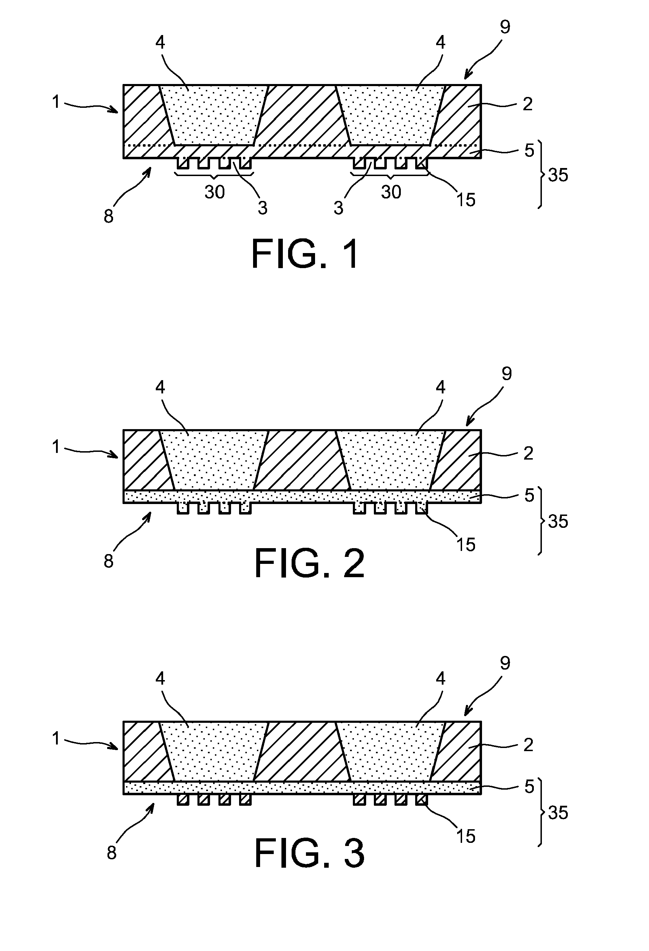

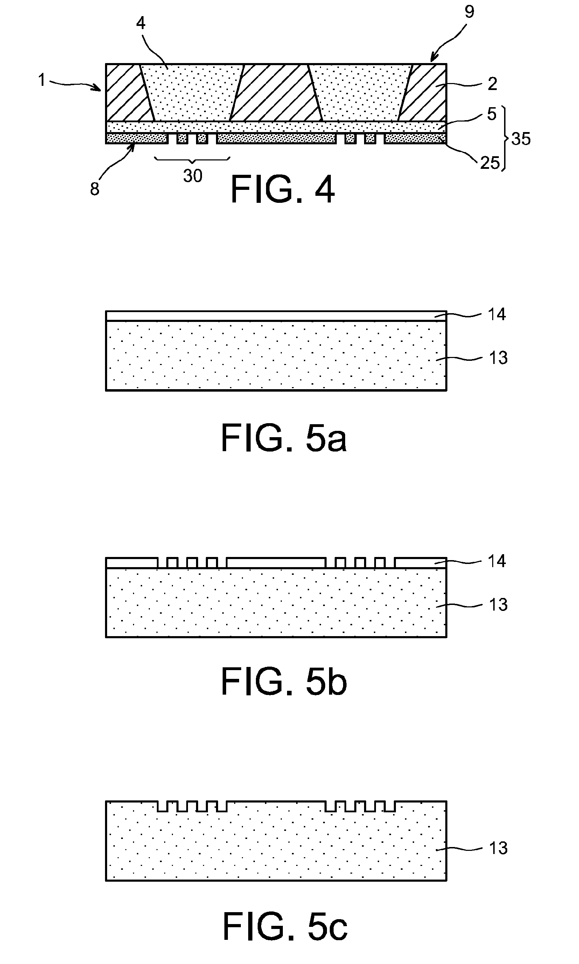

Dans la description qui va suivre, nous allons utiliser les termes opaque et transparent.
Un matériau est dit opaque lorsqu'il ne laisse pas passer la lumière. En fait, on considérera qu'un matériau ayant une épaisseur X est opaque lorsque sa transmittance est inférieure ou égale à 0,2.
Un matériau est dit transparent lorsqu'il laisse passer la lumière. En fait, on considérera qu'un matériau ayant une épaisseur X est transparent lorsque sa transmittance est supérieure ou égale à 0,85 ; un matériau ayant une épaisseur X sera considéré comme étant semi-transparent lorsque sa transmittance est supérieure ou égale à 0,65 et inférieure à 0,85.
Comme illustré dans l'une quelconque des figures 1 à 4, le moule 1 selon l'invention comprend sur une de ses faces (face avant 8) n zones structurées 30 selon des motifs 3 en deux ou trois dimensions de taille micrométrique ou nanométrique, ainsi que n évidements ou cavités sur la face opposée (face arrière 9), réalisés dans une couche rigide et opaque 2 et disposés à l'aplomb des n zones structurées 30, ces n évidements étant remplis avec un matériau transparent pour former n portions 4. Les motifs peuvent être en relief (figures 1 à 3) ou encaissés (en creux) (figure 4) .
De manière détaillée, le moule selon l'invention comporte une couche, rigide ou souple, en un premier matériau 5, comprenant, sur une de ses faces, une couche en un second matériau rigide 15, 25 et, sur la face opposée à la face comportant la couche en second matériau, une couche en un troisième matériau rigide et opaque 2.
Dans la couche en second matériau rigide 15 sont réalisées n zone(s) structurée(s) 30 avec des motifs 3 de taille micrométrique ou nanométrique, n étant un nombre entier supérieur ou égal à 1.
Dans la couche en troisième matériau rigide et opaque 2 à la longueur d'onde déterminée $\lambda_{dét}$ sont réalisés n évidements en regard des n zones structurées les n évidements sont remplis d'un quatrième matériau transparent ou semi-transparent à la longueur d'onde déterminée $\lambda_{dét}$.
Le matériau de la couche rigide 2 est choisi de manière à ce que sa transmittance soit inférieure à la transmittance du matériau des n portions 4.
De plus, les transmittances de la couche de premier matériau, de la couche de second matériau et de la couche de troisième matériau, à la longueur d'onde déterminée $\lambda_{dét}$, sont choisies de manière à ce que la transmission d'une lumière de longueur d'onde déterminée $\lambda_{dét}$ à travers les couches de premier, de second et de troisième matériaux soit inférieure à la transmission de cette lumière de longueur d'onde déterminée $\lambda_{dét}$ à travers l'une des n portions, la couche de premier matériau et la couche de second matériau.
De préférence, le matériau de la couche de troisième matériau est choisi de manière à ce que sa transmittance soit inférieure ou égale à 0,2, préférentiellement inférieure à 0,1.
De préférence, le matériau remplissant les n portions a une transmittance supérieure ou égale à 0,65, préférentiellement supérieure à 0,85.
La couche en troisième matériau 2 assure la tenue mécanique du moule. De préférence, elle a une épaisseur comprise entre 100 micromètres et quelques millimètres.

On rappelle que la longueur d'onde déterminée correspond à la longueur d'onde à laquelle le moule sera par la suite utilisé pour réaliser la nano-impression.

Les couches en premier, second et/ou troisième matériau peuvent être en des matériaux différents ou en un même matériau.

Le premier matériau peut être souple ou rigide, tandis que les second et troisième matériaux sont obligatoirement rigides.

Selon une première variante illustrée dans la figure 1, les couches en premier 5, second 15 et troisième 2 matériaux sont en un même matériau. Il s'agit donc d'un matériau rigide.

Selon une seconde variante illustrée dans la figure 2, les couches en premier 5 et second matériau 15 sont en un même matériau, ce matériau étant alors un matériau rigide et forme une seule couche 35.

Selon une troisième variante illustrée dans la figure 3, les couches en premier 5 et second matériaux 15 sont en deux matériaux différents ; la couche en troisième matériau est ici différente des premier et second matériaux.

Dans les figures 1 à 3 décrites ci-dessus, les motifs sont en relief dans la couche en second matériau (couche 15) ; plus précisément, dans les figures 1 à 3, la couche en second matériau n'est présente qu'au niveau des n zones structurées (la couche en second matériau étant par exemple complètement gravée entre les n zones structurées). Mais les motifs peuvent également être réalisés en creux dans la couche en second matériau, comme représenté dans la figure 4 (couche 25).

Dans les exemples représentés dans les figures 1 à 4, les n évidements sont réalisés dans la totalité de l'épaisseur de la couche en troisième matériau. Il est cependant possible que la profondeur des n évidements soit inférieure à l'épaisseur de la couche en troisième matériau.

Les n évidements ont de préférence une base qui s'amincit au fur et à mesure qu'on se rapproche des n zones structurées (forme d'entonnoir). Cette forme spécifique permet en effet de concentrer la lumière vers les n zones structurées. Il est à noter que la forme en entonnoir des évidements est fixée par la gravure, mais il est tout à fait possible d'avoir des évidements dont les parois latérales sont perpendiculaires à leurs bases.

La couche en second matériau (couche 15 ou 25) est en un matériau rigide, qui est de préférence facilement microstructurable ou nanostructurable (par exemple en silicium).

Les matériaux sont choisis en fonction de leur rigidité ou de leur souplesse et en fonction de la longueur d'onde UV avec laquelle on souhaite utiliser le moule d'impression et en fonction de l'épaisseur de chaque couche constituant le moule. Par exemple, pour les couches de premier, de second et de troisième matériaux, on peut utiliser du silicium, du nitrure de silicium, du carbure de silicium ou un métal (Al, Ti ...). Ces couches auront une transmittance différente selon le matériau utilisé et l'épaisseur de la couche. Le matériau destiné à remplir les n évidements peut quant à lui être choisi parmi la silice, les silicones, le polycarbonate, le polydiméthylsiloxane... selon la longueur d'onde d'utilisation du moule.

En réalisant n évidements dans une couche en matériau rigide 2 et en remplissant ces n évidements avec un matériau dont la transmittance à la longueur d'onde utilisée pour réaliser l'impression est supérieure à celle du matériau rigide 2 de la couche, on peut alors éviter la dispersion latérale de la lumière appliquée sur la face arrière du moule et diriger cette lumière vers les n zones structurées situées en face avant du moule. On obtient donc une meilleure transmission de la lumière à travers le moule.

D'autre part, si le matériau remplissant les n évidements est en outre un matériau souple, il permet également de déposer le matériau souple au plus près des zones structurées présentes sur la face avant du moule et ainsi d'ajuster simplement le comportement mécanique du moule. En amincissant l'épaisseur de la couche en matériau rigide 2 à l'aplomb des zones comprenant les motifs et en remplissant l'espace ainsi créé avec un matériau souple, on peut en effet uniformiser l'effort exercé sur le moule au niveau de ces motifs et atteindre plus rapidement l'état final et uniforme de pressage. On peut ainsi résoudre simultanément la problématique liée à la résolution des motifs et celle liée à l'uniformité de pressage lors de l'impression.

Nous allons à présent décrire un mode de réalisation du moule selon l'invention tel que représenté dans la figure 2, à savoir un moule dans lequel la couche en un premier matériau 5 et la couche en un second matériau 15 sont en un même matériau rigide et forment une seule et même couche 35, ayant une transmittance supérieure à 0,65 à une longueur d'onde déterminée, par exemple à 350 nm, et comportant des zones structurées avec des motifs de taille nanométrique.

On réalise tout d'abord une structuration de la face avant d'un substrat initial 13, par exemple par lithographie (lithographie électronique, optique EUV, X, par FIB...) et par gravure (gravure sèche ionique réactive, usinage ionique, gravure humide...). Pour cela, on dépose une couche de résine 14 sur une face d'un substrat de silicium 13 ou tout autre matériau usuellement utilisé dans les procédés de micro et nano fabrication bien maitrisés pour la fabrication de composants microélectroniques (figure 5a), on insole cette couche de résine 14 selon un motif représentant l'image inversée (empreinte négative) des n zones que l'on souhaite obtenir dans la couche en second matériau du futur moule (figure 5b), on grave la couche de résine insolée 14 et les parties non couvertes par la résine (figure 5c). Par exemple, si l'on souhaite obtenir n zones en relief dans la couche en second matériau du futur moule, on grave ces n zones en creux sur le substrat initial. Dans notre exemple, on choisit d'utiliser un substrat de silicium car le silicium permet de réaliser des gravures avec des résolutions inférieures à 10 nm et des rapports de forme (hauteur / largeur) supérieurs à 10.

On dépose ensuite une couche 350 en un matériau rigide et transparent dans la gamme de longueurs d'onde 193-400 nm sur la face structurée du substrat initial, par exemple une couche d'oxyde de silicium. L'épaisseur de cette couche déposée 350 est supérieure à la hauteur des motifs réalisés dans le substrat initial 13, car cette couche 350 est destinée à former à la fois la couche en second matériau 15 et la couche en premier matériau 5 du moule (voir la figure 2). D'autre part, le dépôt doit être réalisé de manière à remplir convenablement le relief réalisé dans le substrat initial 13.

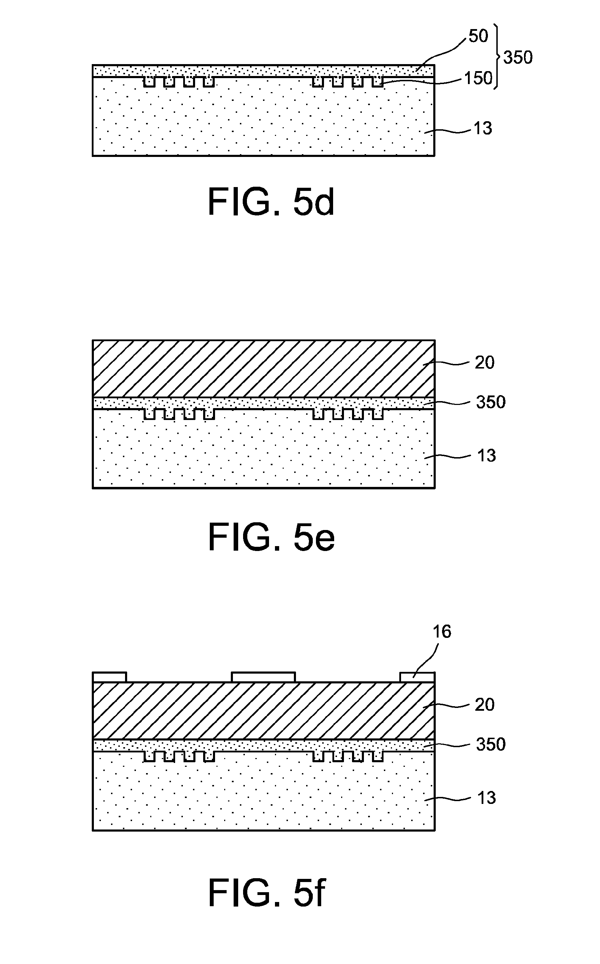

Il est à noter que nous avons représenté dans la figure 5d une couche 150 et une couche 50, formant une seule couche 350, (la couche 150 étant destinée à former la couche en second matériau 15 et la couche 50 étant destinée à former la couche en premier matériau 5 du moule) pour illustrer la possibilité d'avoir une couche 15 et une couche 5 en des matériaux différents.

Puis, on dépose une couche en matériau rigide et opaque 20 sur la couche en matériau rigide et transparent 350 (figure 5e). La couche de matériau rigide 20 peut par exemple être une couche en silicium ou en nitrure de silicium, d'une épaisseur d'au moins 100 micromètres, ces matériaux ayant, pour une telle épaisseur, une transmittance inférieur à 0,2 à une longueur d'onde comprise entre 193 et 400 nm. On réalise ensuite n évidements dans la couche en matériau rigide et opaque 20, en regard des n motifs situées dans la couche 35, par exemple par lithographie et gravure en déposant une couche de résine 16, en l'insolant selon un motif et en la gravant (figure 5f), puis en gravant la couche sous-jacente 20 ; on obtient la couche en troisième matériau 2 comportant n évidements. De préférence, les évidements sont gravés dans toute l'épaisseur de la couche en matériau rigide et opaque 20.

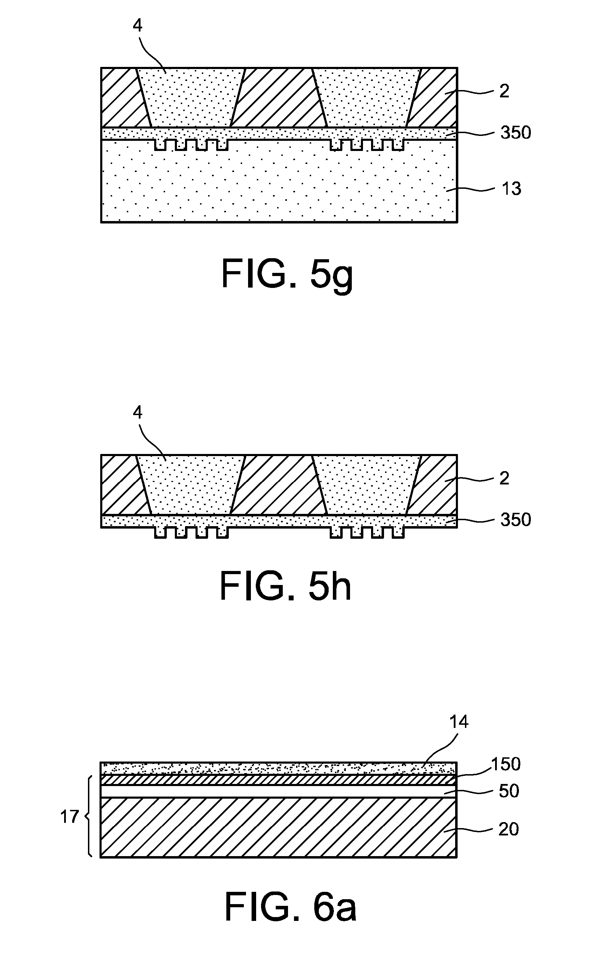

Puis, une couche en un matériau transparent à la longueur d'onde 193-400 nm, qui est de préférence souple, est déposée dans les n évidements et forme les n portions 4 (figure 5g). Par exemple, cette couche déposée dans les n évidements est en polydiméthylsiloxane (PDMS). L'avantage du PDMS est que son module d'Young peut être ajusté en fonction de la proportion du taux d'amorceur contenue dans la préparation du PDMS : le PDMS peut donc être plus ou moins souple.

Il est à noter que, comme expliqué précédemment, les matériaux des différentes couches sont choisis en fonction de leur transmittance d'une longueur d'onde située dans la gamme 193-400 nm.

Le substrat initial 13 est ensuite retiré (figure 5h). Par exemple, on retire la majorité du substrat initial 13 par polissage ou gravure de sa face arrière et le reste du substrat initial est retiré par gravure humide, par exemple par une gravure TMAH ou KOH, afin de graver sélectivement le substrat initial en silicium par rapport à la couche en oxyde de silicium. Il est judicieux de choisir un couple de matériaux pour le substrat initial 13 et la couche de matériau rigide 350, dans laquelle sont réalisées les n zones structurées, qui puisse subir une gravure sélective.

Selon un autre exemple de réalisation, on réalise un moule selon l'invention tel que représenté dans la figure 3, à savoir un moule comprenant une couche en un matériau rigide et transparent à la longueur d'onde déterminée 5, par exemple transparent à 193-400 nm, comportant sur une première face, une couche en un matériau rigide 15, ayant par exemple une transmittance inférieure à 0,2 ou inférieure à 0,65 à la longueur d'onde déterminée, et dans laquelle sont réalisées n zones structurées avec des motifs de taille nanométrique, et sur une seconde face opposée à la première face, une couche en matériau rigide 2, ayant par exemple une transmittance inférieure à 0,2 à la longueur d'onde déterminée, et comportant n évidements 4 remplis d'un matériau ayant par exemple une transmittance supérieure à 0,65.

Tout d'abord, on réalise la structuration d'une face d'un substrat SOI 17 consistant en un empilement d'une couche de silicium 150 ayant une épaisseur de 100 à 500 nm, une couche enterrée d'oxyde de silicium 50 ayant une épaisseur de 100 nm à quelques micromètres, et une couche de silicium 20 ayant une épaisseur d'au moins plusieurs centaines de micromètres (à savoir, supérieure ou égale à 100 micromètres).

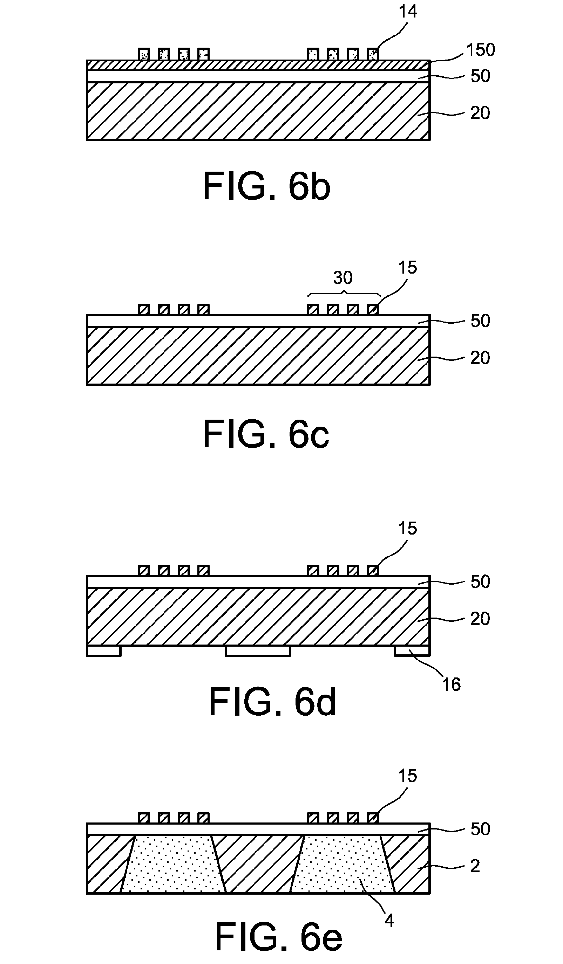

La structuration est obtenue en déposant une couche de résine photosensible 14 sur la face avant du substrat SOI (sur la couche de silicium 150) (figure 6a), en insolant la couche de résine selon un motif représentant les n zones structurées que l'on souhaite obtenir (figure 6b) et en gravant la couche de résine insolée et les parties non couvertes par la résine (figure 6c) : on obtient alors la couche structurée 15. La profondeur des motifs gravés peut être inférieure ou égale à l'épaisseur de la couche de silicium 150 du substrat SOI. Si elle est égale à l'épaisseur de la couche de silicium 150, la couche d'oxyde de silicium 50 du substrat SOI sert alors de couche d'arrêt de la gravure.

On structure ensuite la face arrière du substrat SOI (couche de silicium 20) de manière à ce qu'en regard de chaque zone structurée 30 sur la face avant du substrat corresponde un évidement en face arrière du substrat : on obtient alors la couche structurée 2. Les n évidements peuvent être obtenus par dépôt d'une couche de résine 16 sur la face arrière du substrat SOI, insolation de la couche de résine selon un motif représentant les n évidements que l'on cherche à obtenir, puis gravure de cette couche de résine insolée et des parties non recouvertes par la résine (figure 6d). La gravure peut éventuellement être réalisée jusqu'à atteindre la couche d'oxyde de silicium 50, qui joue alors le rôle de couche d'arrêt de gravure. Ainsi, on est sûr que la gravure en face arrière du substrat ne débouchera pas en face avant sur les motifs des n zones structurées.

On dépose alors une couche en un matériau ayant une transmittance supérieure à 0,65 à la longueur d'onde déterminée, qui est de préférence souple, par exemple du polydiméthylsiloxane (PDMS), sur la face arrière du substrat SOI de manière à remplir des n évidements (figure 6e).

Les deux procédés de réalisation selon l'invention permettent d'obtenir des moules présentant en surface des motifs de taille micrométrique ou nanométrique, tout en utilisant des procédés de lithographie et de gravure simples, bien connus et maîtrisés par l'homme du métier. En particulier, les procédés de réalisation d'un moule selon l'invention sont compatibles avec les procédés habituellement utilisés en microélectronique et dans le domaine des micro-technologies.

Par ailleurs, alors qu'il était nécessaire dans l'art antérieur de graver des substrats en matériau rigide et transparent (c'est-à-dire ayant une transmittance supérieure ou égale à 0,65) de plusieurs centaines de micromètres d'épaisseur, parfois en matériaux très rigides du type silice ou quartz, très difficiles à graver, en particulier pour obtenir des motifs de taille inférieure à 100 nm, il est à présent possible de réaliser la structuration micrométrique ou nanométrique du moule dans une couche d'un matériau facilement structurable, comme par exemple une couche de silicium, sans être limité par le fait que le matériau doive être transparent ou opaque (c'est-à-dire avoir une transmittance inférieure à 0,2) : il suffit alors de déposer cette couche comprenant les n zones structurées sur la couche en matériau rigide et opaque comprenant les n évidements. La fabrication des moules est ainsi considérablement simplifiée et les coûts de production sont, par la même occasion, abaissés.

De plus, comme la diffusion latérale de la lumière est limitée dans le moule, la distance nécessaire entre deux zones structurées adjacentes peut être minimisée ; il est donc possible de placer plus de zones structurées sur un même moule par rapport à l'art antérieur.

Il est également possible d'imprimer sur une même plaque deux zones adjacentes (zone qu'on appellera puce) avec le même moule tout en réduisant la distance entre les deux « puces » adjacentes imprimées. Cela revient en gros à prendre la structure telle qu'illustrée sur les figures et à la déplacer latéralement pour la poser à côté d'une structure identique précédente, le déplacement pouvant être inférieur à 1 micromètre.

**Revendications**

1. Moule (1) pour la lithographie par nano-impression assistée par une longueur d'onde déterminée $\lambda_{dét}$, comprenant une couche en un premier matériau (5) comportant, sur une première face, une couche en un second matériau (15, 25), qui est rigide, et dans laquelle sont réalisées n zone(s) structurée(s) (30) avec des motifs (3) de taille micrométrique ou nanométrique, n étant un nombre entier supérieur ou égal à 1, et, sur la face opposée à ladite première face, une couche en un troisième matériau (2), qui est rigide, dans laquelle sont ménagés n évidements en regard des n zones structurées, lesdits n évidements étant remplis d'un quatrième matériau pour former n portions (4),

la couche en troisième matériau (2) ayant une épaisseur et une composition telles que sa transmittance à la lumière de longueur d'onde déterminée $\lambda_{dét}$ est inférieure à la transmittance à la lumière de longueur d'onde déterminée $\lambda_{dét}$ de l'une quelconque des n portions (4),

et les transmittances des couches de premier (5), de second (15, 25) et de troisième (2) matériaux à la longueur d'onde déterminée $\lambda_{dét}$ étant telles que la transmission d'une lumière de longueur d'onde déterminée $\lambda_{dét}$ à travers les couches de premier (5), de second (15, 25) et de troisième (2) matériaux est inférieure à la transmission de cette lumière de longueur d'onde déterminée $\lambda_{dét}$ à travers l'une quelconque des n portions (4) et les couches de premier (5) et second (15, 25) matériaux.

2. Moule pour la lithographie par nano-impression assistée selon la revendication 1, dans lequel la transmittance de la couche de troisième matériau a une valeur inférieure ou égale à 2/3 de la valeur de la transmittance du quatrième matériau des n portions.

3. Moule pour la lithographie par nano-impression assistée selon la revendication 1, dans lequel la transmittance de la couche de troisième matériau est inférieure ou égale à 0,2 et la transmittance de chacune des n portions est supérieure ou égale à 0,65.

4. Moule pour la lithographie par nano-impression assistée selon la revendication 3, dans lequel la transmittance de la couche de troisième matériau est inférieure à 0,1 et la transmittance de chacune des n portions est supérieure à 0,85.

5. Moule pour la lithographie par nano-impression assistée selon la revendication 1, dans lequel la transmission de la lumière de longueur d'onde déterminée $\lambda_{dét}$ à travers les couches de premier (5), de second (15, 25) et de troisième (2) matériaux est inférieure ou égale à 20% et la transmission de cette lumière de longueur d'onde déterminée $\lambda_{dét}$ à travers l'une quelconque des n portions (4) et les couches de premier (5) et second (15, 25) matériaux est supérieure ou égale à 65%.

6. Moule pour la lithographie par nano-impression assistée selon la revendication 1, dans lequel les n évidements ont une profondeur égale à l'épaisseur de la couche en troisième matériau.

**7.** Moule pour la lithographie par nano-impression assistée selon la revendication 1, dans lequel le premier matériau est un matériau rigide et dans lequel la couche en second matériau (15) est présente uniquement au niveau des n zones structurées (30).

**8.** Moule pour la lithographie par nano-impression assistée selon la revendication 7, dans lequel le premier matériau, le second matériau, et éventuellement le troisième matériau, sont identiques.

**9.** Moule pour la lithographie par nano-impression assistée selon l'une quelconque des revendications 1 à 8, dans lequel les n zones structurées (30) sont réalisées dans la totalité de l'épaisseur de la couche en second matériau (15 ; 25).

**10.** Moule pour la lithographie par nano-impression assistée selon la revendication 1, dans lequel le premier matériau est un matériau souple et dans lequel la couche en second matériau (25) a une épaisseur non nulle en dehors des n zones structurées (30) .

**11.** Moule pour la lithographie par nano-impression assistée selon l'une quelconque des revendications 1 à 10, dans lequel le quatrième matériau des n portions (4) est un matériau souple.

**12.** Moule pour la lithographie par nano-impression assistée selon l'une quelconque des revendications 1 à 11, dans lequel la longueur d'onde déterminée $\lambda_{\text{dét}}$ est située dans la gamme des longueurs d'onde UV, de préférence entre 193 et 400 nm.

**13.** Moule pour la lithographie par nano-impression assistée selon la revendication 1, dans lequel la couche en premier matériau (5) est en silice ou en nitrure de silicium, la couche en second matériau (15, 25) est en silice ou en nitrure de silicium, la couche en troisième matériau (2) est en silicium et les n portions (4) en quatrième matériau sont en polydiméthylsiloxane (PDMS).

**14.** Procédé de réalisation d'un moule (1) pour la lithographie par nano-impression assistée par une longueur d'onde déterminée $\lambda_{\text{dét}}$ selon l'une quelconque des revendications 1 à 13, comprenant les étapes suivantes :

a) fourniture d'un substrat initial (13) ;
b) structuration d'une face dudit substrat initial (13), appelée face avant, selon un motif représentant l'empreinte négative des n zones structurées (30) que l'on souhaite obtenir dans la couche en second matériau (15, 25) du moule ;
c) dépôt d'un empilement comprenant trois couches sur la face avant du substrat initial (13), la première couche (150) recouvrant le relief formé à l'étape b) de structuration et formant la couche en second matériau (15, 25) du moule, ladite première couche (150) et le substrat initial (13) étant en des matériaux différents, la seconde couche (50) recouvrant la première couche (150) et formant la couche en premier matériau (5) du moule, et la troisième couche (20) recouvrant la seconde couche et formant la couche en troisième matériau (2) du moule,
d) structuration de la troisième couche (20) de manière à obtenir n évidements, les n évidements étant en regard des n zones structurées (30) ;
e) formation des n portions (4) du moule par dépôt d'une couche en quatrième matériau sur la troisième couche de manière à recouvrir les n évidements ;
f) retrait du substrat initial (13) ;
la troisième couche (20) ayant une épaisseur et une composition telles que sa transmittance à la lumière de longueur d'onde déterminée $\lambda_{\text{dét}}$ est inférieure à la transmittance à la lumière de longueur d'onde déterminée $\lambda_{\text{dét}}$ de l'une quelconque des n portions (4),
et les transmittances des première (150), seconde (50) et troisième (20) couches à la longueur d'onde déterminée $\lambda_{\text{dét}}$ étant telles que la transmission d'une lumière de longueur d'onde déterminée $\lambda_{\text{dét}}$ à travers les première (150), seconde (50) et troisième (20) couches est inférieure à la transmission de cette lumière de longueur d'onde déterminée $\lambda_{\text{dét}}$ à travers l'une quelconque des n portions (4) et les première (150) et seconde (50) couches.

**15.** Procédé de réalisation d'un moule (1) pour la lithographie par nano-impression assistée selon la revendication 14, dans lequel la transmittance de la troisième couche (20) est inférieure ou égale à 0,2, de préférence inférieure à 0,1, et la transmittance de chacune des n portions (4) est supérieure ou égale à 0,65, de préférence supérieure à 0,85.

**16.** Procédé de réalisation d'un moule (1) pour la lithographie par nano-impression assistée selon la revendication 14, dans lequel la transmission de la lumière de longueur d'onde déterminée $\lambda_{\text{dét}}$ à travers les première (150), seconde (50) et troisième (20) couches est inférieure ou égale à 20% et la transmission de cette lumière de longueur d'onde déterminée $\lambda_{\text{dét}}$ à travers l'une quelconque des n portions (4) et les première (150) et seconde (50) couches est supérieure ou égale à 65%.

**17.** Procédé de réalisation d'un moule pour la lithographie par nano-impression assistée selon la revendication 14, dans lequel l'étape b) comprend les étapes suivantes :

- dépôt d'une couche de résine photosensible (14) sur une face du substrat initial (13) ;
- insolation de la couche de résine photosensible selon un motif d'insolation représentant l'empreinte négative des n zones structurées que l'on souhaite obtenir dans la première couche ;
- gravure de la couche de résine insolée (14) ;
- gravure des parties de la face du substrat initial (13) non recouvertes par la couche de résine.

18. Procédé de réalisation d'un moule pour la lithographie par nano-impression assistée selon la revendication 14, dans lequel l'étape d) comprend les étapes suivantes :

- dépôt d'une couche de résine photosensible (16) sur la face de la troisième couche ;
- insolation de la couche de résine photosensible selon un motif d'insolation représentant l'empreinte positive des n évidements que l'on souhaite obtenir dans la troisième couche ;
- gravure de la couche de résine insolée ;
- gravure des parties de la face de la troisième couche non recouvertes par la couche de résine.

19. Procédé de réalisation d'un moule pour la lithographie par nano-impression assistée par une longueur d'onde déterminée $\lambda_{dét}$ selon 1"une quelconque des revendications 1 à 13, comprenant les étapes suivantes :

a) fourniture d'un empilement comprenant trois couches, la première couche (150) formant la couche en second matériau (15) du moule, la seconde couche (50) recouvrant la première couche (150) et formant la couche en premier matériau (5) du moule, et la troisième couche (20) recouvrant la seconde couche (50) et formant la couche en troisième matériau (2) du moule,
b) structuration de la première couche (150) de l'empilement de manière à obtenir les n zones structurées (30) du moule ;
c) réalisation des n évidements dans la troisième couche (20) de l'empilement, les n évidements étant en regard des n zones structurées (30) ;
d) formation des n portions (4) du moule par dépôt d'une couche en quatrième matériau sur la troisième couche (20) de manière à recouvrir les n évidements ;
la troisième couche (20) ayant une épaisseur et une composition telles que sa transmittance à la lumière de longueur d'onde déterminée $\lambda_{dét}$ est inférieure à la transmittance à la lumière de longueur d'onde déterminée $\lambda_{dét}$ de l'une quelconque des n portions (4),
et les transmittances des première (150), seconde (50) et troisième (20) couches à la longueur d'onde déterminée $\lambda_{dét}$ étant telles que la transmission d'une lumière de longueur d'onde déterminée $\lambda_{dét}$ à travers les première (150), seconde (50) et troisième (20) couches est inférieure à la transmission de cette lumière de longueur d'onde déterminée $\lambda_{dét}$ à travers l'une quelconque des n portions (4) et les première (150) et seconde (50) couches.

20. Procédé de réalisation d'un moule (1) pour la lithographie par nano-impression assistée selon la revendication 19, dans lequel la transmittance de la troisième couche (20) est inférieure ou égale à 0,2, de préférence inférieure à 0,1, et la transmittance de chacune des n portions (4) est supérieure ou égale à 0,65, de préférence supérieure à 0,85.

21. Procédé de réalisation d'un moule (1) pour la lithographie par nano-impression assistée selon la revendication 19, dans lequel la transmission de la lumière de longueur d'onde déterminée $\lambda_{dét}$ à travers les première (150), seconde (50) et troisième (20) couches est inférieure ou égale à 20% et la transmission de cette lumière de longueur d'onde déterminée $\lambda_{dét}$ à travers l'une quelconque des n portions (4) et les première (150) et seconde (50) couches est supérieure ou égale à 65%.

22. Procédé de réalisation d'un moule pour la lithographie par nano-impression assistée selon la revendication 19, dans lequel l'étape b) comprend les étapes suivantes :

- dépôt d'une couche de résine photosensible sur la première couche de l'empilement ;
- insolation de la couche de résine photosensible selon un motif d'insolation représentant les motifs de taille micrométrique ou nanométrique agencés selon les n zones structurées à obtenir ;
- gravure de la couche de résine insolée ;
- gravure des parties de la face de la première couche non recouvertes par la couche de résine.

23. Procédé de réalisation d'un moule pour la lithographie par nano-impression assistée selon la revendication 19, dans lequel l'étape c) comprend les étapes suivantes :

- dépôt d'une couche de résine photosensible sur la troisième couche de l'empilement ;
- insolation de la couche de résine photosensible selon un motif d'insolation représentant les n évidements à obtenir ;
- gravure de la couche de résine insolée ;
- gravure des parties de la face de la troisième couche non recouvertes par la couche de résine.

**Patentansprüche**

1. Form (1) für die Nanoprägelithografie, die durch eine bestimmte Wellenlänge $\lambda_{dét}$ unterstützt wird, umfassend eine Schicht aus einem ersten Material (5), die an einer ersten Seite eine Schicht aus einem zweiten Material (15, 25) umfasst, welche starr ist, und in der n strukturierte Zone(n) (30) mit Motiven (3) in Mikrometer- oder Nanometergröße realisiert sind, wobei n eine ganze Zahl größer oder gleich 1 ist, sowie, auf der der ersten Seite gegenüberliegenden Seite, eine Schicht aus einem dritten Material (2), welche starr ist, in der n Aussparungen gegenüber den n strukturierten Zonen vorgesehen sind, wobei die n Aussparungen mit einem vierten Material gefüllt sind, um n Bereiche (4) zu bilden,
wobei die Schicht aus drittem Material (2) eine Dicke und eine Zusammensetzung derart hat, dass ihre Transmittanz für das Licht der bestimmten Wellenlänge $\lambda_{dét}$ kleiner ist als die Transmittanz eines der n Bereiche (4) für das Licht der bestimmten Wellenlänge $\lambda_{dét}$,
und wobei die Transmittanzen der Schichten aus erstem (5), aus zweitem (15, 25) und aus drittem (2) Material für die bestimmte Wellenlänge $\lambda_{dét}$ derart sind, dass die Transmission eines Lichts der bestimmten Wellenlänge $\lambda_{dét}$ durch die Schichten aus erstem (5), aus zweitem (15, 25) und aus drittem (2) Material kleiner ist als die Transmission dieses Lichts der bestimmten Wellenlänge $\lambda_{dét}$ durch einen der n Bereiche (4) und die Schichten aus erstem (5) und aus zweitem (15, 25) Material hindurch.

2. Form für die unterstützte Nanoprägelithografie nach Anspruch 1, bei der die Transmittanz der Schicht aus drittem Material einen Wert kleiner oder gleich 2/3 des Werts der Transmittanz des vierten Materials der n Bereiche hat.

3. Form für die unterstützte Nanoprägelithografie nach Anspruch 1, bei der die Transmittanz der Schicht aus drittem Material kleiner oder gleich 0,2 ist, und die Transmittanz jedes der n Bereiche größer oder gleich 0,65 ist.

4. Form für die unterstützte Nanoprägelithografie nach Anspruch 3, bei der die Transmittanz der Schicht aus drittem Material kleiner als 0,1 ist, und die Transmittanz jedes der n Bereiche größer als 0,85 ist.

5. Form für die unterstützte Nanoprägelithografie nach Anspruch 1, bei der die Transmission des Lichts der bestimmten Wellenlänge $\lambda_{dét}$ durch die Schichten aus erstem (5), aus zweitem (15, 25) und aus drittem (2) Material hindurch kleiner oder gleich 20 % ist, und die Transmission dieses Lichts der bestimmten Wellenlänge $\lambda_{dét}$ durch einen der n Bereiche (4) und die Schichten aus erstem (5) und aus zweitem (15, 25) Material hindurch größer oder gleich 65 % ist.

6. Form für die unterstützte Nanoprägelithografie nach Anspruch 1, bei der die n Aussparungen eine Tiefe gleich der Dicke der Schicht aus drittem Material haben.

7. Form für die unterstützte Nanoprägelithografie nach Anspruch 1, bei der das erste Material ein starres Material ist, und bei der die Schicht aus zweitem Material (15) ausschließlich im Bereich der n strukturierten Zonen (30) vorhanden ist.

8. Form für die unterstützte Nanoprägelithografie nach Anspruch 7, bei der das erste Material, das zweite Material und gegebenenfalls das dritte Material identisch sind.

9. Form für die unterstützte Nanoprägelithografie nach einem der Ansprüche 1 bis 8, bei der die n strukturierten Zonen (30) in der gesamten Dicke der Schicht aus zweitem Material (15, 25) realisiert sind.

10. Form für die unterstützte Nanoprägelithografie nach Anspruch 1, bei der das erste Material ein weiches Material ist, und bei der die Schicht aus zweitem Material (25) außerhalb der n strukturierten Zone (30) eine Dicke ungleich 0 hat.

11. Form für die unterstützte Nanoprägelithografie nach einem der Ansprüche 1 bis 10, bei der das vierte Material der n Bereiche (4) ein weiches Material ist.

12. Form für die unterstützte Nanoprägelithografie nach einem der Ansprüche 1 bis 11, bei der die bestimmte Wellenlänge $\lambda_{dét}$ im UV-Wellenlängenbereich liegt, vorzugsweise zwischen 193 und 400 nm.

13. Form für die unterstützte Nanoprägelithografie nach Anspruch 1, bei der die Schicht aus erstem Material (5) aus Siliziumdioxid oder aus Siliziumnitrid ist, die Schicht aus zweitem Material (15, 25) aus Siliziumdioxid oder aus Siliziumnitrid ist, die Schicht aus drittem Material (2) aus Silizium ist, und die n Bereiche (4) aus viertem Material aus Polydimthylsiloxan (PDMS) sind.

14. Verfahren zur Herstellung einer Form (1) für die Nanoprägelithografie, die durch eine bestimmte Wellenlänge $\lambda_{dét}$ unterstützt wird, gemäß einem der Ansprüche 1 bis 13, umfassend die folgenden Schritte:

  a) Bereitstellen eines Anfangssubstrats (13);
  b) Strukturieren einer Seite des Anfangssubstrats (13), genannt Vorderseite, gemäß einem Motiv, das den negativen Abdruck der n strukturierten Zonen (30) darstellt, die man in der Schicht aus zweitem Material (15, 25) der Form erhalten möchte;

c) Aufbringen eines Stapels, umfassend drei Schichten, auf der Vorderseite des Anfangssubstrats (13), wobei die erste Schicht (150) das im Strukturierungsschritt b) gebildete Relief bedeckt und die Schicht aus zweitem Material (15, 25) der Form bildet, wobei die erste Schicht (150) und das Anfangssubstrat (13) aus unterschiedlichen Materialien sind, wobei die zweite Schicht (50) die erste Schicht (150) bedeckt und die Schicht aus erstem Material (5) der Form bildet, und wobei die dritte Schicht (20) die zweite Schicht bedeckt und die Schicht aus drittem Material (2) der Form bildet,

d) Strukturieren der dritten Schicht (20) derart, dass n Aussparungen erhalten werden, wobei die n Aussparungen gegenüber den n strukturierten Zonen (30) sind;

e) Bilden von n Bereichen (4) der Form durch Aufbringen einer Schicht aus viertem Material auf der dritten Schicht derart, dass die n Aussparungen bedeckt werden;

f) Entfernen des Anfangssubstrats (13);

wobei die dritte Schicht (20) eine Dicke und eine Zusammensetzung derart aufweist, dass ihre Transmittanz für das Licht der bestimmten Wellenlänge $\lambda_{dét}$ kleiner ist als die Transmittanz eines der n Bereiche (4) für das Licht der bestimmten Wellenlänge $\lambda_{dét}$,

und wobei die Transmittanzen der ersten (150), der zweiten (50) und der dritten (20) Schicht für die bestimmte Wellenlänge $\lambda_{dét}$ derart sind, dass die Transmission eines Lichts der bestimmten Wellenlänge $\lambda_{dét}$ durch die erste (150), die zweite (50) und die dritte (20) Schicht hindurch kleiner ist als die Transmission dieses Lichts der bestimmten Wellenlänge $\lambda_{dét}$ durch einen der n Bereiche (4) und die erste (150) und die zweite (50) Schicht hindurch.

15. Verfahren zur Herstellung einer Form (1) für die unterstützte Nanoprägelithografie nach Anspruch 14, bei dem die Transmittanz der dritten Schicht (20) kleiner oder gleich 0,2 ist, vorzugsweise kleiner als 0,1, und die Transmittanz jedes der n Bereiche (4) größer oder gleich 0,65 ist, vorzugsweise größer als 0,85.

16. Verfahren zur Herstellung einer Form (1) für die unterstützte Nanoprägelithografie nach Anspruch 14, bei der die Transmission des Lichts der bestimmten Wellenlänge $\lambda_{dét}$ durch die erste (150), die zweite (50) und die dritte (20) Schicht hindurch kleiner oder gleich 20 % ist, und die Transmission dieses Lichts der bestimmten Wellenlänge $\lambda_{dét}$ durch einen der n Bereiche (4) und die erste (150) und die zweite (50) Schicht hindurch größer oder gleich 65 % ist.

17. Verfahren zur Herstellung einer Form für die unterstützte Nanoprägelithografie nach Anspruch 14, bei dem der Schritt b) die folgenden Schritte umfasst:

- Aufbringen einer Schicht aus fotoempfindlichen Harz (14) auf einer Seite des Anfangssubstrats (13);
- Insolation der Schicht aus fotoempfindlichen Harz gemäß einem Insolationsmotiv, das den negativen Abdruck der n strukturierten Zonen darstellt, die man in der ersten Schicht erhalten möchte;
- Gravieren der insolierten Harzschicht (14);
- Gravieren der Teile der Seite des Anfangssubstrats (13), die nicht durch die Harzschicht bedeckt sind.

18. Verfahren zur Herstellung einer Form zur unterstützten Nanoprägelithografie nach Anspruch 14, bei dem der Schritt d) die folgenden Schritte umfasst:

- Aufbringen einer Schicht aus fotoempfindlichen Harz (16) auf der Seite der dritten Schicht;
- Insolation der Schicht aus fotoempfindlichen Harz gemäß einem Insolationsmotiv, das den positiven Abdruck der n Aussparungen darstellt, die man in der dritten Schicht erhalten möchte;
- Gravieren der insolierten Harzschicht;
- Gravieren der Teile der Seite der dritten Schicht, die nicht von der Harzschicht bedeckt sind.

19. Verfahren zur Herstellung einer Form für die Nanoprägelithografie, die durch eine bestimmte Wellenlänge $\lambda_{dét}$ unterstützt wird, gemäß einem der Ansprüche 1 bis 13, umfassend die folgenden Schritte:

a) Bereitstellen eines Stapels, der drei Schichten umfasst, wobei die erste Schicht (150) die Schicht aus zweitem Material (15) der Form bildet, wobei die zweite Schicht (50) die erste Schicht (150) bedeckt und die Schicht aus erstem Material (5) der Form bildet, und wobei die dritte Schicht (20) die zweite Schicht (50) bedeckt und die Schicht aus drittem Material (2) der Form bildet,

b) Strukturieren der ersten Schicht (150) des Stapels derart, dass die n strukturierten Zonen (30) der Form erhalten werden;

c) Realisieren der n Aussparungen in der dritten Schicht (20) des Stapels, wobei die n Aussparungen den n strukturierten Zonen (30) gegenüber sind;

d) Bilden der n Bereiche (4) der Form durch Aufbringen einer Schicht aus viertem Material auf der dritten Schicht (20) derart, dass die n Aussparungen bedeckt sind;

wobei die dritte Schicht (20) eine Dicke und eine Zusammensetzung derart hat, dass ihre Transmittanz für das Licht der bestimmten Wellenlänge $\lambda_{dét}$ kleiner ist als die Transmittanz eines der n Bereiche (4) für das Licht der bestimmten Wellenlänge $\lambda_{dét}$,

und wobei die Transmittanzen der ersten (150), der zweiten (50) und der dritten (20) Schicht für die bestimmte Wellenlänge $\lambda_{dét}$ derart sind, dass die Transmission eines Lichts der bestimmten Wellenlänge $\lambda_{dét}$ durch die erste (150), die zweite (50) und die dritte (20) Schicht hindurch kleiner ist als die Transmission dieses Lichts der bestimmten Wellenlänge $\lambda_{dét}$ durch einen der n Bereiche (4) und die erste (150) und die zweite (50) Schicht hindurch.

20. Verfahren zur Herstellung einer Form (1) für die unterstützte Nanoprägelithografie nach Anspruch 19, bei dem die Transmittanz der dritten Schicht (20) kleiner oder gleich 0,2 ist, vorzugsweise kleiner als 0,1, und die Transmittanz jedes der n Bereiche (4) größer oder gleich 0,65 ist, vorzugsweise größer als 0,85.

21. Verfahren zur Herstellung einer Form (1) für die unterstützte Nanoprägelithografie nach Anspruch 19, bei dem die Transmission des Lichtes der bestimmten Wellenlänge $\lambda_{dét}$ durch die erste (150), die zweite (50) und die dritte (20) Schicht hindurch kleiner oder gleich 20 % ist, und die Transmission dieses Lichts der bestimmten Wellenlänge $\lambda_{dét}$ durch einen der n Bereiche (4) und die erste (150) und die zweite (50) Schicht hindurch größer oder gleich 65 % ist.

22. Verfahren zur Herstellung einer Form für die unterstützte Nanoprägelithografie nach Anspruch 19, bei dem der Schritt b) die folgenden Schritte umfasst:

- Aufbringen einer Schicht aus fotoempfindlichen Harz auf der ersten Schicht des Stapels;
- Insolation der Schicht aus fotoempfindlichen Harz gemäß einem Insolationsmotiv, das die Motive mit Mikrometer- oder Nanometergröße darstellt, die gemäß den zu erhaltenden n strukturierten Zonen angeordnet sind;
- Gravieren der insolierten Harzschicht;
- Gravieren der Teile der Seite der ersten Schicht, die nicht von der Hartzschicht bedeckt sind.

23. Verfahren zur Herstellung einer Form für die unterstützte Nanoprägelithografie nach Anspruch 19, bei dem der Schritt c) die folgenden Schritte umfasst:

- Aufbringen einer Schicht aus fotoempfindlichen Harz auf der dritten Schicht des Stapels;
- Insolation der Schicht aus fotoempfindlichen Harz gemäß einem Insolationsmotiv, dass die zu erhaltenden n Aussparungen darstellt;
- Gravieren der insolierten Harzschicht;
- Gravieren der Teile der Seite der dritten Schicht, die nicht von der Harzschicht bedeckt sind.

**Claims**

1. A mold (1) for nanoimprint lithography assisted by a determined wavelength $\lambda_{det}$, comprising a layer made from a first material (5) including, on a first face, a layer made from a second material (15, 25), that is rigid, and in which n structured zones (30) with micrometric or nanometric patterns (3) are made, n being an integer greater than or equal to 1, and, on the face opposite said first face, a layer made from a third material (2), which is rigid, in which n recesses are formed opposite the n structured zones, said n recesses being filled with a fourth material to form n portions (4),

   the layer made from a third material (2) having a thickness and a composition such that its transmittance to light with determined wavelength $\lambda_{det}$ is lower than the transmittance to light of the determined wavelength $\lambda_{det}$ of any one of the n portions (4),

   and the transmittances of the layers made of the first (5), second (15, 25) and third (2) materials at the determined wavelength $\lambda_{det}$ being such that the transmission of a light with determined wavelength $\lambda_{det}$ through the layers of the first (5), second (15, 25) and third (2) materials is less than the transmission of said light with determined wavelength $\lambda_{det}$ through any one of the n portions (4) and the layers made from the first (5) and second (15, 25) materials.

2. The mold for assisted nanoimprint lithography according to claim 1, wherein the transmittance of the layer made of the third material has a value less than or equal to 2/3 of the value of the transmittance of the material of the n portions.

3. The mold for assisted nanoimprint lithography according to claim 1, wherein the transmittance of the third layer is less than or equal to 0.2, and the transmittance of each of the n portions is greater than or equal to 0.65.

4. The mold for assisted nanoimprint lithography according to claim 3, wherein the transmittance of the layer of third material is less than 0.1 and the transmittance of each of the n portions is greater than 0.85.

5. The mold for assisted nanoimprint lithography according to claim 1, wherein the transmission of the light with determined wavelength $\lambda_{det}$ through the layers of first (5), second (15, 25) and third (2) materials is less than or equal to 20% and the transmission of said light with determined wavelength $\lambda_{det}$ through any one of the n portions (4) and the layers of first (5) and second (15, 25) materials is greater than or equal to 65%.

6. The mold for assisted nanoimprint lithography according to claim 1, wherein the n recesses have a depth equal to the thickness of the layer of third material.

7. The mold for assisted nanoimprint lithography according to claim 1, wherein the first material is a rigid material and wherein the layer of second material (15) is present only at the n structured zones (30).

8. The mold for assisted nanoimprint lithography according to claim 7, wherein the first material, the second material, and possibly the third material, are identical.

9. The mold for assisted nanoimprint lithography according to any one of claims 1 to 8, wherein the n structured zones (30) are made in the entire thickness of the layer of second material (15; 25).

10. The mold for assisted nanoimprint lithography according to claim 1, wherein said first material is a flexible material and wherein the layer of second material (25) has a non-zero thickness outside the n structured zones (30).

11. The mold for assisted nanoimprint lithography according to any one of claims 1 to 10, wherein the fourth material of the n portions (4) is a flexible material.

12. The mold for assisted nanoimprint lithography according to any one of claims 1 to 11, wherein the determined wavelength $\lambda_{det}$ is situated in the UV wavelength range, and preferably between 193 and 400 nm.

13. The mold for assisted nanoimprint lithography according to claim 1, wherein the layer made from the first material (5) is silica or silicon nitride, the layer of second material (15, 25) is silica or silicon nitride, the layer of third material (2) is silicon and the n portions (4) of fourth material are made from polydimethylsiloxane (PDMS).

14. A method for making a mold (1) for nanoimprint lithography assisted by a determined wavelength $\lambda_{det}$ according to any one of claims 1 to 13, comprising the following steps:

a) providing an initial substrate (13);
b) structuring one face of said initial substrate (13), called front face, according to a pattern representing the negative imprint of the n structured zones (30) one wishes to obtain in the layer of second material (15, 25) of the mold;
c) depositing a stack comprising three layers on the front face of the initial substrate (13), the first layer (150) covering the relief formed in structuring step b) and forming the layer of second material (15, 25) of the mold, said first layer (150) and the initial substrate (13) being made from different materials, the second layer (50) covering the first layer (150) and forming the layer of first material (5) of the mold, and the third layer (20) covering the second layer and forming the layer of third material (2) of the mold,
d) structuring the third layer (20) so as to obtain n recesses, the n recesses being opposite the n structured zones (30);
e) forming n portions (4) of the mold by depositing a layer of fourth material on the third layer so as to cover the n recesses;
f) removing the initial substrate (13);
the third layer (20) having a thickness and a composition such that the transmittance to light with determined wavelength $\lambda_{det}$ is less than the transmittance to light of determined wavelength $\lambda_{det}$ of any one of the n portions (4),
and the transmittances of the first (150), second (50) and third (20) layers at the determined wavelength $\lambda_{det}$ being such that the transmission of light with determined wavelength $\lambda_{det}$ through the first (150), second (50) and third (20) layers is less than the transmission of said light with determined wavelength $\lambda_{det}$ through any one of the n portions (4) and the first (150) and second (50) layers.

15. The method for making a mold (1) for assisted nanoimprint lithography according to claim 14, wherein the transmittance of the third layer (20) is less than or equal to 0.2, preferably less than 0.1, and the transmittance of each of the n portions (4) is greater than or equal to 0.65, preferably greater than 0.85.

16. The method for making a mold (1) for assisted nanoimprint lithography according to claim 14, wherein the transmission of the light with determined wavelength $\lambda_{det}$ through the first (150), second (50) and third (20) layers is less than or equal to 20% and the transmission of this light with determined wavelength $\lambda_{det}$ through any one of the n portions (4) and the first (150) and second (50) layers is greater than or equal to 65%.

17. The method for making a mold for assisted nanoimprint lithography according to claim 14, wherein step b) comprises the following steps:

- depositing a layer of photosensitive resin (14) on a face of the initial substrate (13);
- insulating the layer of photosensitive resin following an insulation pattern representing the negative imprint of the n structured zones one wishes to obtain in the first layer;
- etching the insulated resin layer (14);
- etching portions of the face of the initial substrate (13) not covered with the layer of resin.

18. The method for making a mold for assisted nanoimprint lithography according to claim 14, wherein step d) comprises the following steps:

- depositing a layer of photosensitive resin (16) on the face of the third layer;
- insulating the layer of photosensitive resin following an insulation pattern representing the positive imprint of the n recesses one wishes to obtain in the third layer;
- etching the insulated resin layer;
- etching portions of the face of the third layer not covered with the resin layer.

19. A method for making a mold for nanoimprint lithography assisted by a determined wavelength $\lambda_{det}$ according to any one of claims 1 to 13, comprising the following steps:

a) providing a stack comprising three layers, the first layer (150) forming the layer of second material (15) of the mold, the second layer (50) covering the first layer (150) and forming the layer of first material (5) of the mold, and the third layer (20) covering the second layer (50) and forming the layer of third material (2) of the mold,

b) structuring the first layer (150) of the stack so as to obtain the n structured zones (30) of the mold;

c) making n recesses in the third layer (20) of the stack, the n recesses being opposite the n structured zones (30);

d) forming the n portions (4) of the mold by depositing a layer of fourth material (20) on the third layer so as to cover the n recesses;

the third layer (20) having a thickness and a composition such that its transmittance to light with determined wavelength $\lambda_{det}$ is less than the transmittance to light with determined wavelength $\lambda_{det}$ of any one of the n portions (4),

and the transmittances of the first (150), second (50) and third (20) layers at the determined wavelengths $\lambda_{det}$ being such that the transmission of light with a determined wavelength $\lambda_{det}$ through the first (150), second (50) and third (20) layers is less than the transmission of that light with determined wavelength $\lambda_{det}$ through any one of the n portions (4) and the first (150) and second (50) layers.

20. The method for making a mold (1) for assisted nanoimprint lithography according to claim 19, wherein the transmittance of the third layer (20) is less than or equal to 0.2, preferably less than 0.1, and the transmittance of each of the n portions (4) is greater than or equal to 0.65, preferably greater than 0.85.

21. The method for making a mold (1) for assisted nanoimprint lithography according to claim 19, wherein the transmission of the light with determined wavelength $\lambda_{det}$ through the first (150), second (50) and third (20) layers is less than or equal to 20% and the transmission of said light with determined wavelength $\lambda_{det}$ through any one of the n portions (4) and the first (150) and second (50) layers is greater than or equal to 65%.

22. The method for making a mold (1) for assisted nanoimprint lithography according to claim 19, wherein step b) comprises the following steps:

- depositing a layer of photosensitive resin on the first layer of the stack;
- insulating the layer of photosensitive resin following an insulating pattern representing the micrometric or nanometric patterns arranged according to the n structured zones to be obtained;
- etching the layer of insulated resin;
- etching the portions of the face of the first layer not covered by the layer of resin.

23. The method for making a mold for assisted nanoimprint lithography according to claim 19, wherein step c) comprises the following steps:

- depositing a layer of photosensitive resin on the third layer of the stack;
- insulating the layer of photosensitive resin using an insulating pattern representing the n recesses to be obtained;
- etching the layer of insulated resin;
- etching the portions of the face of the third layer not covered by the layer of resin.

**FIG. 1**

**FIG. 2**

**FIG. 3**

**FIG. 4**

**FIG. 5a**

**FIG. 5b**

**FIG. 5c**

FIG. 5d

FIG. 5e

FIG. 5f

FIG. 5g

FIG. 5h

FIG. 6a

14

150

50

20

## FIG. 6b

30    15

50

20

## FIG. 6c

15

50

20

16

## FIG. 6d

15

50

2

4

## FIG. 6e

**RÉFÉRENCES CITÉES DANS LA DESCRIPTION**

**Documents brevets cités dans la description**

- US 2010015270 A1